# EUROPEAN PATENT APPLICATION

(11) **EP 1 848 047 A2**
(43) Date of publication of application: **24.10.2007**
(21) Application number: 07007521.3
(22) Date of filing: 12.04.2007
(51) Int. Cl.: H01L 45/00

(54) **Transitioning the state of phase change material by annealing**

(30) Priority: 19.04.2006 US 406699
(71) Applicant: Qimonda AG, 81739 München (DE); International Business Machines Corporation, Armonk, NY 10504 (US)
(72) Inventor: Rossnagel, Stephen M., Pleasantville, NY 10570-2301 (US); Philipp, Jan Boris, Peekskill, NY 10566 (US)
(74) Representative: Jehle, Volker Armin

(57) **Abstract**

A semiconductor device includes a preprocessed wafer and an annealed phase change material layer contacting the preprocessed wafer. The semiconductor device includes a first material layer contacting the annealed phase change material layer.

## Description

### Background

One type of non-volatile memory is resistive memory. Resistive memory utilizes the resistance value of a memory element to store one or more bits of data. For example, a memory element programmed to have a high resistance value may represent a logic "1" data bit value, and a memory element programmed to have a low resistance value may represent a logic "0" data bit value. The resistance value of the memory element is switched electrically by applying a voltage pulse or a current pulse to the memory element. One type of resistive memory is phase change memory. Phase change memory uses a phase change material for the resistive memory element.

Phase change memories are based on phase change materials that exhibit at least two different states. Phase change material may be used in memory cells to store bits of data. The states of phase change material may be referred to as amorphous and crystalline states. The states may be distinguished because the amorphous state generally exhibits higher resistivity than does the crystalline state. Generally, the amorphous state involves a more disordered atomic structure, while the crystalline state involves a more ordered lattice. Some phase change materials exhibit more than one crystalline state, e.g. a face-centered cubic (FCC) state and a hexagonal closest packing (HCP) state. These two crystalline states have different resistivities and may be used to store bits of data.

Phase change in the phase change materials may be induced reversibly. In this way, the memory may change from the amorphous state to the crystalline state and from the crystalline state to the amorphous state in response to temperature changes. The temperature changes to the phase change material may be achieved in a variety of ways. For example, a laser can be directed to the phase change material, current may be driven through the phase change material, or current can be fed through a resistive heater adjacent the phase change material. In any of these methods, controllable heating of the phase change material causes controllable phase change within the phase change material.

A phase change memory including a memory array having a plurality of memory cells that are made of phase change material may be programmed to store data utilizing the memory states of the phase change material. One way to read and write data in such a phase change memory device is to control a current and/or a voltage pulse that is applied to the phase change material. The level of current and/or voltage generally corresponds to the temperature induced within the phase change material in each memory cell.

During the fabrication of phase change memory or other devices utilizing phase change material, the transition of phase change material from an amorphous state to a crystalline state reduces the volume of phase change material. If during the fabrication of a device, phase change material is deposited at a low temperature, the phase change material is in the amorphous state. During further processing steps, the phase change material may be heated above the crystallization temperature. With the phase change material heated above the crystallization temperature, the phase change material transitions from the amorphous state to a crystalline state. The transition from the amorphous state to the crystalline state reduces the volume of phase change material by up to approximately 10%. This volume reduction may be significant enough to cause peeling of the layers of material deposited over the phase change material.

For these and other reasons, there is a need for the present invention.

### Summary

One embodiment of the present invention provides a semiconductor device. The semiconductor device includes a preprocessed wafer and an annealed phase change material layer contacting the preprocessed wafer. The semiconductor device includes a first material layer contacting the annealed phase change material layer.

### Brief Description of the Drawings

The accompanying drawings are included to provide a further understanding of the present invention and are incorporated in and constitute a part of this specification. The drawings illustrate the embodiments of the present invention and together with the description serve to explain the principles of the invention. Other embodiments of the present invention and many of the intended advantages of the present invention will be readily appreciated as they become better understood by reference to the following detailed description. The elements of the drawings are not necessarily to scale relative to each other. Like reference numerals designate corresponding similar parts.
Figure 1 is a diagram illustrating one embodiment of the transition of phase change material from an amorphous state, to an FCC crystalline state, and to an HCP crystalline state.
Figure 2 illustrates a cross-sectional view of one embodiment of a preprocessed wafer.
Figure 3 illustrates a cross-sectional view of one embodiment of a preprocessed wafer and an amorphous phase change material layer.
Figure 4 illustrates a cross-sectional view of one embodiment of the preprocessed wafer, amorphous phase change material layer, and a first material layer.
Figure 5 illustrates a cross-sectional view of one embodiment of forces generated within the phase change material layer when the phase change material layer transitions from the amorphous state to a crystalline state.
Figure 6 illustrates a cross-sectional view of one embodiment of peeling of the first material layer after transitioning the phase change material layer from the amorphous state to the crystalline state.
Figure 7 illustrates a cross-sectional view of one embodiment of a preprocessed wafer.
Figure 8 illustrates a cross-sectional view of one embodiment of the preprocessed wafer and an amorphous phase change material layer.
Figure 9 illustrates a cross-sectional view of one embodiment of forces generated within the phase change material layer when the phase change material layer transitions from the amorphous state to a crystalline state by annealing.
Figure 10 illustrates a cross-sectional view of one embodiment of the processed wafer, crystalline phase change material layer, and a first material layer.
Figure 11 illustrates a cross-sectional view of one embodiment of the preprocessed wafer, crystalline phase change material layer, and first material layer after further processing.

### Detailed Description

In the following Detailed Description, reference is made to the accompanying drawings, which form a part hereof, and in which is shown by way of illustration specific embodiments in which the invention may be practiced. In this regard, directional terminology, such as "top," "bottom," "front," "back," "leading," "trailing," etc., is used with reference to the orientation of the Figure(s) being described. Because components of embodiments of the present invention can be positioned in a number of different orientations, the directional terminology is used for purposes of illustration and is in no way limiting. It is to be understood that other embodiments may be utilized and structural or logical changes may be made without departing from the scope of the present invention. The following detailed description, therefore, is not to be taken in a limiting sense, and the scope of the present invention is defined by the appended claims.

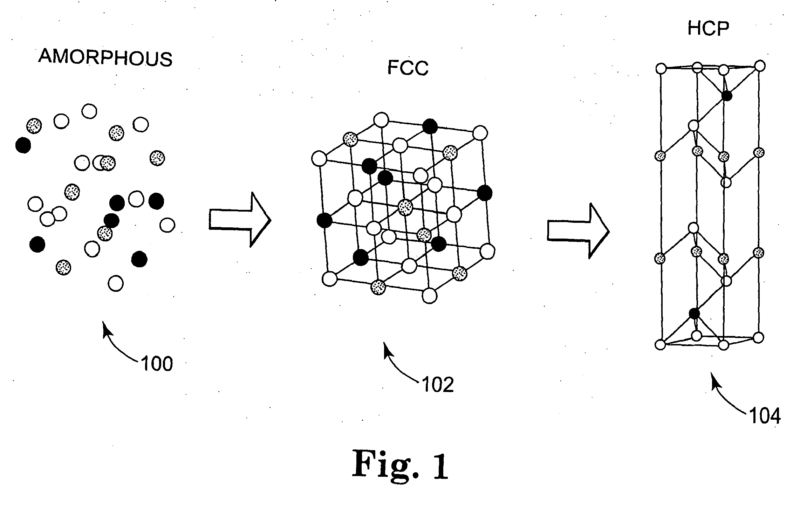

Figure 1 is a diagram illustrating one embodiment of the transition of phase change material from an amorphous state at 100, to a face-centered cubic (FCC) crystalline state at 102, and to a hexagonal closest packing (HCP) crystalline state at 104. Amorphous phase change material at 100 is heated to approximately 175°C to provide FCC crystalline phase change material at 102. The volume of phase change material from the amorphous state at 100 to the FCC crystalline state at 102 is reduced by approximately 7%. Further heating of the phase change material in the FCC crystalline state at 102 to approximately 350°C provides phase change material in the HCP crystalline state at 104. The volume of phase change material from the FCC crystalline state at 102 to the HCP crystalline state at 104 is reduced by approximately 2%.

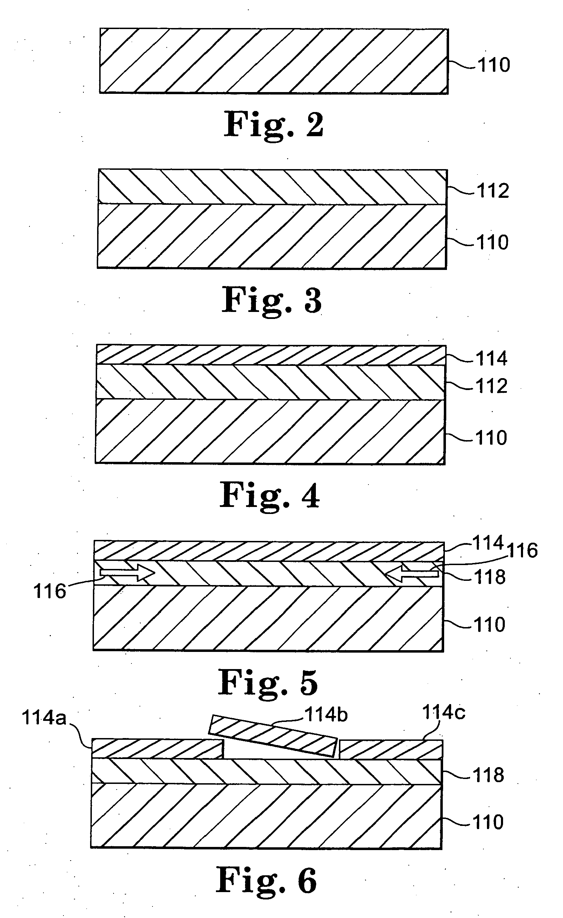

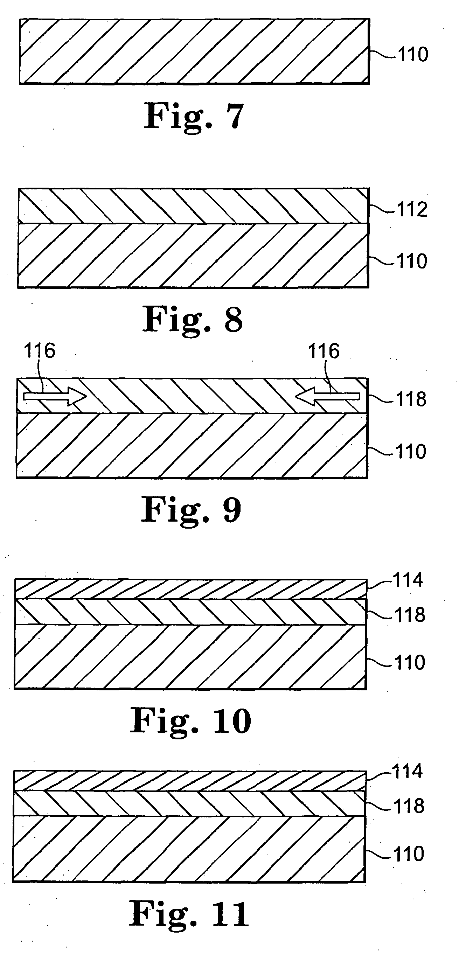

A reduction in the volume of the phase change material may occur during fabrication of a phase change memory device or other device that uses phase change material. The reduction in volume may cause tensile stress, which may lead to peeling of material layers deposited on a phase change material layer as described and illustrated with reference to the following Figures 2-6. To prevent the peeling due to the tensile stress resulting from the change in volume of the phase change material, the phase change material is annealed after deposition. The annealing of the phase change material transitions the phase change material from the amorphous state to the FCC crystalline state or to the HCP crystalline state before additional processing steps are performed. One embodiment of a process for fabricating a phase change memory device or other device using phase change material is described and illustrated with reference to the following Figures 7-11.

Figure 2 illustrates a cross-sectional view of one embodiment of a preprocessed wafer 110. Preprocessed wafer 110 includes any suitable material layers or device features for the particular device being fabricated. In one embodiment, preprocessed wafer 110 includes transistors and contact plugs for a phase change memory device. In other embodiments, preprocessed wafer 110 includes other suitable device features for other devices that include phase change material.

Figure 3 illustrates a cross-sectional view of one embodiment of preprocessed wafer 110 and an amorphous phase change material layer 112. Phase-change material layer 112 may be made up of a variety of materials in accordance with the present invention. Generally, chalcogenide alloys that contain one or more elements from group VI of the periodic table are useful as such materials. In one embodiment, phase-change material layer 112 is made up of a chalcogenide compound material, such as GeSbTe, SbTe, GeTe or AgInSbTe. In another embodiment, phase-change material layer 112 is chalcogen free, such as GeSb, GaSb, InSb, or GeGaInSb. In other embodiments, phase-change material layer 112 is made up of any suitable material including one or more of the elements Ge, Sb, Te, Ga, As, In, Se, and S.

A phase change material, such as a chalcogenide compound material or other suitable phase change material, is deposited over preprocessed wafer 110 to provide phase change material layer 112. Phase change material layer 112 is deposited using chemical vapor deposition (CVD), atomic layer deposition (ALD), metal organic chemical vapor deposition (MOCVD), plasma vapor deposition (PVD), jet vapor deposition (JVP), or other suitable deposition technique.

Figure 4 illustrates a cross-sectional view of one embodiment of preprocessed wafer 110, amorphous phase change material layer 112, and a first material layer 114. In one embodiment, first material layer 114 is a conductive material, such as TiN, TaN, W, Al, Cu, TiSiN, TaSiN, or other suitable conductive material. In another embodiment, first material layer 114 is a semiconductor material. In another embodiment, first material layer 114 is an insulator material, such as SiO₂ Boro-PhosphoSilicate Glass (BPSG), BoroSilicate Glass (BSG), low-k material, or another suitable dielectric material. The conductive, semiconductor, or insulator material is deposited over amorphous phase change material layer 112 to provide first material layer 114. First material layer 114 is deposited using CVD, ALD, MOCVD, PVD, JVP, or other suitable deposition technique. In one embodiment, first material layer 114 is an electrode material layer for fabricating a phase change memory device. In other embodiments, first material layer 114 is for fabricating other suitable devices.

Figure 5 illustrates a cross-sectional view of one embodiment of forces 116 generated within phase change material layer 118 when phase change material layer 112 transitions from the amorphous state to a crystalline state. Forces 116 are generated in response to the deposition of first material layer 114 or further processing steps that heat phase change material layer 112. Phase change material layer 112 is heated above the crystallization temperature to provide crystalline phase change material layer 118. The transition of amorphous phase change material layer 112 to crystalline phase change material layer 118 reduces the volume of the phase change material. The reduction in volume of the phase change material generates forces 116.

Figure 6 illustrates a cross-sectional view of one embodiment of peeling of first material layer 114 after transitioning from amorphous phase change material layer 112 to crystalline phase change material layer 118. Forces 116 generated in phase change material layer 118 due to the reduction in volume cause peeling of first material layer 114 as indicted by 114a-114c. One embodiment of a method for preventing this peeling is described and illustrated with reference to the following Figures 7-11.

Figure 7 illustrates a cross-sectional view of one embodiment of a preprocessed wafer 110. Preprocessed wafer 110 includes any suitable material layers or device features for the particular device being fabricated. In one embodiment, preprocessed wafer 110 includes transistors and contact plugs for a phase change memory device. In other embodiments, preprocessed wafer 110 includes other suitable device features for other devices that include phase change material.

Figure 8 illustrates a cross-sectional view of one embodiment of preprocessed wafer 110 and an amorphous phase change material layer 112. A phase change material, such as a chalcogenide compound material or other suitable phase change material, is deposited over preprocessed wafer 110 to provide phase change material layer 112. Phase change material layer 112 is deposited using CVD, ALD, MOCVD, PVD, JVP, or other suitable deposition technique.

Figure 9 illustrates a cross-sectional view of one embodiment of forces 116 provided within phase change material layer 118 when amorphous phase change material layer 112 transitions to a crystalline state phase change material layer 118 by annealing. Amorphous phase change material layer 112 is annealed to provide crystalline phase change material layer 118. Amorphous phase change material layer 112 is annealed using a heated chuck with a clamp, a vacuum chuck, an E-chuck, or other suitable annealing technique. The annealing is performed in-situ or ex-situ. The annealing reduces the volume of the phase change material, which generates forces 116.

Figure 10 illustrates a cross-sectional view of one embodiment of preprocessed wafer 110, crystalline phase change material layer 118, and a first material layer 114. In one embodiment, first material layer 114 is a conductive material, such as TiN, TaN, W, Al, Cu, TiSiN, TaSiN, or other suitable conductive material. In another embodiment, first material layer 114 is a semiconductor material. In another embodiment, first material layer 114 is an insulator material, such as SiO₂, BPSG, BSG, low-k material, or another suitable dielectric material. The conductive, semiconductor, or insulator material is deposited over amorphous phase change material layer 112 to provide first material layer 114. First material layer 114 is deposited using CVD, ALD, MOCVD, PVD, JVP, or other suitable deposition technique. In one embodiment, first material layer 114 is an electrode material layer for fabricating a phase change memory device. In other embodiments, first material layer 114 is for fabricating other suitable devices.

Figure 11 illustrates a cross-sectional view of one embodiment of preprocessed wafer 110, crystalline phase change material layer 118, and first material layer 114 after further processing. With phase change material layer 118 in the crystalline state, deposition of first material layer 114 or further processing after deposition of first material layer 114 does not transition the state of the phase change material. Therefore, the volume of phase change material is not further reduced. With no additional reduction in volume of the phase change material, no additional forces 116 are generated. With no additional forces 116 generated, first material layer 114 and other material layers deposited above phase change material layer 118 do not peel.

Embodiments of the present invention provide a method for preventing peeling of material layers deposited above a phase change material layer during fabrication. By annealing the amorphous phase change material after deposition to transition the phase change material to a crystalline state, no tensile stress in introduced in further processing steps. In this way, peeling of other material layers deposited over the phase change material is prevented.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor device comprising:
a preprocessed wafer;
an annealed phase change material layer contacting the preprocessed wafer; and
a first material layer contacting the annealed phase change material layer.

2. The semiconductor device of claim 1, wherein the semiconductor device comprises a phase change memory.

3. The semiconductor device of claim 1, wherein the annealed phase change material layer is defined by having been transitioned from an amorphous state to a crystalline state.

4. The semiconductor device of claim 3, wherein the crystalline state comprises a face-centered cubic crystalline state.

5. The semiconductor device of claim 3, wherein the crystalline state comprises a hexagonal closest packing crystalline state.

6. The semiconductor device of claim 1, wherein the first material layer comprises a conductive material.

7. The semiconductor device of claim 1, wherein the first material layer comprises an insulator material.

8. A phase change memory comprising:
a preprocessed wafer;
an annealed phase change material layer contacting the preprocessed wafer; and
an electrode material layer contacting the annealed phase change material layer.

9. The semiconductor device of claim 8, wherein the phase change material layer comprises at least one of Ge, Sb, Te, Ga, As, In, Se, and S.

10. The semiconductor device of claim 8, wherein the phase change material layer comprises Ge₂Sb₂Te₅.

11. The semiconductor device of claim 8, wherein the electrode material layer comprises one of Ti, TiN, Ta, TaN, W, Al, and Cu.

12. A semiconductor device comprising:
a preprocessed wafer;
a phase change material layer deposited on the preprocessed wafer;
a first material layer deposited on the phase change material layer; and
means for preventing the first material layer from peeling.

13. The semiconductor device of claim 12, wherein the semiconductor device comprises a phase change memory.

14. The semiconductor device of claim 12, wherein the phase change material layer comprises at least one of Ge, Sb, Te, Ga, As, In, Se, and S.

15. The semiconductor device of claim 12, wherein the phase change material layer comprises Ge₂Sb₂Te₅.

16. The semiconductor device of claim 12, wherein the first material layer comprises one of Ti, TiN, Ta, TaN, W, Al, and Cu.

17. A method for fabricating a semiconductor device, the method comprising:
providing a preprocessed wafer;
depositing a phase change material layer in an amorphous state over the preprocessed wafer; and
annealing the phase change material layer to transition the phase change material from the amorphous state to a crystalline state.

18. The method of claim 17, wherein annealing the phase change material layer comprises in-situ annealing of the phase change material layer.

19. The method of claim 17, wherein annealing the phase change material layer comprises ex-situ annealing of the phase change material layer.

20. The method of claim 17, wherein annealing the phase change material layer comprises thermally annealing the phase change material layer.

21. The method of claim 17, wherein annealing the phase change material layer comprises heating the phase change material layer.

22. The method of claim 17, further comprising:
depositing a first material layer over the phase change material layer.

23. A method for fabricating a phase change memory, the method comprising:
providing a preprocessed wafer including transistors and contact plugs;
depositing a phase change material layer in an amorphous state over the preprocessed wafer; and
annealing the phase change material layer to transition the phase change material from the amorphous state to a crystalline state.

24. The method of claim 23, wherein depositing the phase change material layer comprises depositing a material including at least one of Ge, Sb, Te, Ga, As, In, Se, and S.

25. The method of claim 23, wherein depositing the phase change material layer comprises depositing Ge₂Sb₂Te₅.

26. The method of claim 23, further comprising:
depositing an electrode material layer over the phase change material layer.

27. The method of claim 26, wherein depositing the electrode material layer comprises depositing one of Ti, TiN, Ta, TaN, W, Al, and Cu.
